# EUROPÄISCHE PATENTSCHRIFT

(11) **EP 2 232 598 B1**
(45) Veröffentlichungstag und Bekanntmachung des Hinweises auf die Patenterteilung: **04.11.2015**
(21) Anmeldenummer: 09700832.0
(22) Anmeldetag: 09.01.2009
(51) Int. Cl.: H01L 41/053, H01L 41/083

(54) **PIEZOELEKTRISCHE AKTOREINHEIT**
PIEZOELECTRIC ACTUATOR UNIT
ENSEMBLE ACTIONNEUR PIÉZOÉLECTRIQUE

(30) Priorität: 10.01.2008 DE 102008003821
(43) Veröffentlichungstag der Anmeldung: 29.09.2010
(73) Patentinhaber: Epcos AG, 81669 München (DE)
(72) Erfinder: RINNER, Franz, A-8530 Deutschlandsberg (AT); THANNER, Herbert, J., A-8051 Graz (AT); FELLNER, Siegfried, A-8413 St. Georgen (AT)
(74) Vertreter: Epping - Hermann - Fischer
(86) Internationale Anmeldenummer: PCT/DE2009/000006
(87) Internationale Veröffentlichungsnummer: WO 2009/086815

(56) Entgegenhaltungen:
- WO-A-2007/128948
- DE-A1-102007 000 210
- KIEFER J ET AL: "Piezo actuator assembly" RESEARCH DISCLOSURE, Bd. 503, Nr. 48, März 2006 (2006-03), XP007136019

## Beschreibung

Es wird ein Piezoaktor in einer piezoelektrischen Aktoreinheit mit Mittel zur Verlängerung seiner Lebensdauer beschrieben.

Mittel zum Schutz eines Piezoaktors vor Umwelteinflüssen sind von Bedeutung, wenn die Lebensdauer des Piezoaktors möglichst lang gehalten werden soll.

Aus DE 102006025177 A1 ist ein in einem Metallrohr untergebrachter Piezoaktor bekannt, wobei zwischen dem Metallrohr und dem Piezoaktor ein Druckübertragungsmedium aus mikroporösen bzw. Schaum-, Geflecht- oder Gewebekörpern vorhanden ist.

Das Dokument Kiefer et al.: "Piezo actuator assembly" (XP007136019) offenbart Piezoaktoren mit einer Hülle, die aus Polyphenylensulfid oder Flüssigkristallpolymeren gebildet sind.

Das Dokument WO 2007/128948 A beschreibt Materialien für eine Hülle eines Aktors.

Das Dokument DE 10 2007 000 210 A1 beschreibt einen Piezoaktuator 10, der von einem Formharz 41 umgeben ist. Das Formharz 41 wird von einer Hülse 42 umgeben, welche als Material Polyphenylensulfid, Polyethylenterephthalat oder Nylon 66 aufweist.

Eine zu lösende Aufgabe besteht darin, einen Piezoaktor mit Mittel anzugeben, die ihn vor schädlichen Umwelteinflüssen schützen.

Es wird eine piezoelektrische Aktoreinheit angegeben, welche einen Piezoaktor sowie eine den Piezoaktor umgebende Vergussmasse aufweist, wobei die Vergussmasse in einer Hülse angeordnet ist, welche ein hydrophobes Material gemäß Anspruch 1 enthält.

Es wurde experimentell festgestellt, dass das Eindringen von Feuchtigkeit in einen Piezoaktor seine Lebensdauer deutlich herabsenken kann. Das hydrophobe Material der Hülse der hiermit vorgestellten Aktoreinheit hat den Vorteil, diese Feuchtigkeit vom Piezoaktor fernzuhalten. Der Anteil an hydrophobem Material in der Hülse kann derart hoch gewählt sein, dass keine Feuchtigkeit oder nahezu keine Feuchtigkeit zum Piezoaktor dringen kann.

Der Piezoaktor bzw. das piezoelektrische Vielschichtbauelement umfasst vorzugsweise einen Stapel von piezokeramischen Schichten, welche eine PZT Keramik enthalten können, sowie Elektrodenschichten, welche vorzugsweise eines der folgenden Materialien enthalten: Silber, Palladium, Platin, Kupfer, Nickel.

Vorzugsweise ist an zwei Seitenflächen des Stapels je ein Außenkontakt aufgebracht. Die Außenkontakte können ein Material enthalten, welches in den Elektrodenschichten enthalten ist. Die Außenkontakte können als Pins oder als Schichten bzw. Schichtenfolgen ausgeführt sein. Jeder Außenkontakt kontaktiert einen Stapel von Elektrodenschichten, wobei die Elektrodenschichten eines jeden Stapels mit je einem an die entsprechende Seitenfläche des Stapels herangeführten Ende mit einem Außenkontakt kontaktiert sind.

Die Hülse enthält gemäß einer Ausführungsform ein Material, welches eine Verbindung mit der Vergussmasse eingeht, wodurch möglichst wenige Hohlräume zwischen der Vergussmasse und der Hülse entstehen.

Es wird bevorzugt, dass die Hülse aus Materialien geschaffen ist, welche derart chemisch stabil sind, dass sie keine chemische Reaktion mit zumindest einem Teil des Piezoaktors eingehen, auch wenn sie von der Hülse zum entsprechenden Teil des Piezoaktors diffundieren sollten. Insbesondere wird bevorzugt, dass das hydrophobe Material diese chemisch stabile Eigenschaft aufweist. Als zumindest ein Teil des Piezoaktors wird sowohl jede äußere Oberfläche einer piezokeramischen Schicht sowie jede Oberfläche eines Außenkontakts verstanden. Somit kann die Hülse derart geschaffen sein, dass sie kein Material enthält, welches mit einem piezokeramischen Material oder mit einem elektrisch leitfähigen Material eines Außenkontakts eine chemische Reaktion eingeht.

Der Anteil an hydrophobem Material der Hülse ist vorzugsweise derart gewählt, dass die Hülse bei Raumtemperatur und bei einer Luftfeuchtigkeit von zwischen 30 und 60% eine maximale Feuchtigkeitsaufnahme von 0,1 Gew.-% bis 0,3 Gew.-%, vorzugsweise 0,2 Gew.-%, aufweist.

Erfindungsgemäß enthält die Hülse als thermoplastischen Polyester Polybutylenterephthalat (PBT). Es wurde gefunden, dass dieses Material hydrophobe Eigenschaften aufweist und der Hülse gleichzeitig eine zur Formstabilisierung der Vergussmasse ausreichende mechanische Festigkeit bzw. Stabilität verleiht sowie gegenüber Temperaturen, wie sie beispielsweise im Motorraum eines Kraftfahrzeugs auftreten, beständig ist. Darüber hinaus hat Polybutylenterephthalat als in der Hülse enthaltenes Material den Vorteil, dass dessen Teilmengen aufgrund ihrer chemischen Stabilität nicht zum Piezoaktor absondern und diesen chemisch verunreinigen.

Gemäß einer Ausführungsform der Aktoreinheit enthält die Hülse sowohl hydrophobes Material als auch ein die mechanische Festigkeit der Hülse stärkendes Material, beispielsweise Glasfaser. Glasfasern in der Hülse haben den Vorteil, die mechanische Festigkeit sowie die Temperaturbeständigkeit der Hülse zu erhöhen.

Vorzugsweise sind die Glasfaser zu einem Anteil von 20 bis 40 Gew.-%, vorzugsweise 30 Gew.-%, in der Hülse vorhanden.

Das Elastizitätsmodul der Hülse bezogen auf Zugspannungen liegt vorzugsweise zwischen 9000 und 11000 MPa, vorzugsweise bei 10000 MPa. Die Bruchspannung der Hülse liegt vorzugsweise zwischen 130 und 140 MPa, vorzugsweise bei 135 MPa.

Gemäß einer Ausführungsform der Aktoreinheit enthält die zwischen dem Piezoaktor und der Hülse vorhandene Vergussmasse ein Material, welches bei Kontakt mit einem Kraftstoff wie zum Beispiel Benzin oder Diesel nicht zersetzt bzw. der Kraftstoff keine ätzende Wirkung auf das Material aufweist.

Gemäß einer Ausführungsform der Vergussmasse umfasst sie ein Silikon-Elastomer.

Die Vergussmasse kann Additive wie zum Beispiel Quarzsand und / oder einen Haftvermittler enthalten. Der Haftvermittler verbessert das Anhaften der Vergussmasse an die Außenseite des Piezoaktors sowie an die Innenseite der Hülse.

Gemäß einer Ausführungsform ist die Hülse spritzgegossen.

Die beschriebenen Gegenstände werden anhand der folgenden Ausführungsbeispiele und Figuren näher erläutert. Dabei zeigt:
- Figur 1: eine perspektivische Ansicht einer Aktoreinheit,
- Figur 2A: einen Querschnitt der mit der Figur 1 gezeigten Aktoreinheit,
- Figur 2B: einen Längsschnitt der mit der Figur 1 gezeigten Aktoreinheit.

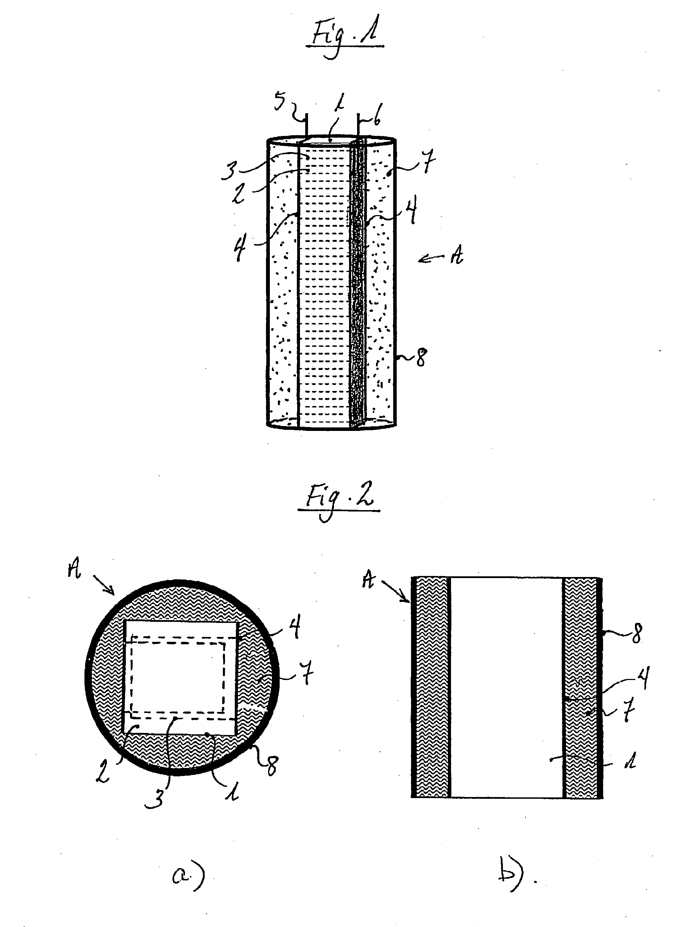

Die mit der Figur 1 gezeigte Aktoreinheit A weist einen von einer Vergussmasse 7 umhüllten Piezoaktor 1 bzw. piezoelektrisches Vielschichtbauelement auf, welches einen Stapel von übereinander angeordneten piezokeramischen Schichten 2 und Elektrodenschichten 3 aufweist. Die Elektrodenschichten 3 bilden zwei an verschiedenen Seitenflächen des Stapels herangeführte Stapel von Elektrodenschichten, welche jeweils mit einem an einer entsprechenden Seitenfläche des Stapels angeordneten Außenkontakt 4 kontaktiert sind. Die Außenkontakte 4 sind jeweils mit einem als Draht oder Pin ausführten Anschlusselement 5, 6 verbunden, das den Piezoaktor 1 nach außen elektrisch kontaktieren lässt. Die Vergussmasse 7 enthält vorzugsweise ein Silikon-Elastomer. Neben dem Silikon-Elastomer enthält die Vergussmasse 7 vorzugsweise ein Quarzsand sowie haftvermittelnde Materialien. Die Vergussmasse 7 steht mit der Außenseite des Piezoaktors in Verbindung, d.h. sowohl mit Außenflächen von piezokeramischen Schichten 2 als auch mit den Außenflächen der Außenkontakte 4. Nach außen wird die Vergussmasse 7 von einer Hülse 8 begrenzt. Die Höhe bzw. Länge der Hülse 8 entspricht in etwa der Höhe des Piezoaktors 1. Die Hülse 8 besteht aus Polybutylenterephthalat sowie Glasfaser, wobei Letzteres zu einem Anteil von 30 Gew.-% in der Hülse vorhanden ist.

Beim Querschnittsbild gemäß Figur 2a sowie beim Längsschnittbild gemäß Figur 2b der mit der Figur 1 vorgestellten Aktoreinheit A wird gezeigt, wie der Umriss des Piezoaktors samt Außenkontakte 4 und äußere Oberflächen von piezokeramischen Schichten 2 von der Vergussmasse 7 umgeben ist. Die Vergussmasse wird von der vorzugsweise zylinderförmigen Hülse 8 nach außen begrenzt. Figur 2a zeigt zusätzlich die überlappende Anordnung von gegenpoligen, mit jeweils einem anderen Außenkontakt 4 kontaktierten, rechteckförmigen Elektrodenschichten 3.

### Bezugszeichenliste

- A: piezoelektrische Aktoreinheit

- 1: Piezoaktor
- 2: piezokeramische Schicht
- 3: Elektrodenschicht
- 4: Außenkontakt
- 5: erstes Anschlusselement
- 6: zweites, gegenpoliges Anschlusselement
- 7: Vergussmasse
- 8: Hülse

## Patentansprüche

1. Piezoelektrische Aktoreinheit (A), umfassend einen Piezoaktor (1) sowie eine den Piezoaktor umgebende Vergussmasse (7), wobei die Vergussmasse in einer Hülse (8) angeordnet ist, welche als hydrophobes Material einen thermoplastischen Polyester enthält, **dadurch gekennzeichnet, dass** der thermoplastische Polyester Polybutylenterephthalat umfasst.

2. Piezoelektrische Aktoreinheit (A) nach Anspruch 1, bei der die Hülse (8) ein Material enthält, welches eine Verbindung mit der Vergussmasse (7) eingeht, wodurch möglichst wenige Hohlräume zwischen der Vergussmasse und der Hülse entstehen.

3. Piezoelektrisch Aktoreinheit (A) nach einem der Ansprüche 1 oder 2, bei der die Hülse (8) ein Material enthält, welches mit zumindest einem Teil des Piezoaktors (1) keine chemische Reaktion eingeht.

4. Piezoelektrische Aktoreinheit (A) nach einem der vorhergehenden Ansprüche, bei der die Hülse (8) zusätzlich ein die mechanische Stabilität der Hülse stärkendes Material enthält.

5. Piezoelektrische Aktoreinheit (A) nach Anspruch 4, bei dem das die mechanische Stabilität der Hülse (8) stärkende Material Glasfaser umfasst.

6. Piezoelektrische Aktoreinheit (A) nach Anspruch 5, bei dem die Glasfaser zu einem Anteil von zwischen 20 und 40 Gew.-% in der Hülse vorhanden ist.

7. Piezoelektrische Aktoreinheit (A) nach einem der vorhergehenden Ansprüche, bei der die Vergussmasse (7) zumindest eines der folgenden Materialien enthält: ein Silikon-Elastomer, Quarzsand, einen Haftvermittler.

8. Piezoelektrische Aktoreinheit (A) nach einem der vorhergehenden Ansprüche, bei dem der Piezoaktor (1) einen Stapel von piezokeramischen Schichten (2) sowie Elektrodenschichten (3) umfasst und wobei je an einer Seitenfläche des Stapels angeordnete elektrisch gegenpolige Außenkontakte (4) Elektrodenschichten (3) kontaktieren.

## Claims

1. Piezoelectric actuator unit (A) comprising a piezo actuator (1) and also an encapsulation compound (7) which surrounds the piezo actuator, wherein the encapsulation compound is arranged in a sleeve (8) which contains, as hydrophobic material, a thermoplastic polyester, **characterized in that** the thermoplastic polyester comprises polybutylene terephthalate.

2. Piezoelectric actuator unit (A) according to Claim 1, in which the sleeve (8) contains a material which coalesces with the encapsulation compound (7), as a result of which as few cavities as possible are produced between the encapsulation compound and the sleeve.

3. Piezoelectric actuator unit (A) according to either of Claims 1 and 2, in which the sleeve (8) contains a material which does not chemically react with at least a portion of the piezo actuator (1).

4. Piezoelectric actuator unit (A) according to one of the preceding claims, in which the sleeve (8) additionally contains a material which increases the mechanical stability of the sleeve.

5. Piezoelectric actuator unit (A) according to Claim 4, in which the material which increases the mechanical stability of the sleeve (8) comprises glass fibre.

6. Piezoelectric actuator unit (A) according to Claim 5, in which the glass fibre is contained in the sleeve in a proportion of between 20 and 40% by weight.

7. Piezoelectric actuator unit (A) according to one of the preceding claims, in which the encapsulation compound (7) contains at least one of the following materials: a silicone elastomer, quartz sand, an adhesion promoter.

8. Piezoelectric actuator unit (A) according to one of the preceding claims, in which the piezo actuator (1) comprises a stack of piezoceramic layers (2) and also electrode layers (3), and wherein external contacts (4) which have opposing electrical polarities and are each arranged on a side surface of the stack make contact with electrode layers (3).

## Revendications

1. Unité piézoélectrique d'actionneur (A) comprenant un piézoactionneur (1) ainsi qu'une pâte d'encapsulation (7) qui englobe le piézoactionneur,
la pâte d'encapsulation étant disposée dans une douille (8) qui contient comme matériau hydrophobe un polyester thermoplastique,
**caractérisée en ce que**
le polyester thermoplastique contient du poly(téréphtalate de butylène).

2. Unité piézoélectrique d'actionneur (A) selon la revendication 1, dans laquelle la douille (8) contient un matériau qui entre en liaison avec la pâte d'encapsulation (7), ce qui permet de former le moins possible de cavités entre la pâte d'encapsulation et la douille.

3. Unité piézoélectrique d'actionneur (A) selon l'une des revendications 1 ou 2, dans laquelle la douille (8) contient un matériau qui n'entre pas en réaction chimique avec au moins une partie du piézoactionneur (1).

4. Unité piézoélectrique d'actionneur (A) selon l'une des revendications précédentes, dans laquelle la douille (8) contient de plus un matériau qui renforce la stabilité mécanique de la douille.

5. Unité piézoélectrique d'actionneur (A) selon la revendication 4, dans laquelle le matériau qui renforce la stabilité mécanique de la douille (8) comporte des fibres de verre.

6. Unité piézoélectrique d'actionneur (A) selon la revendication 5, dans laquelle les fibres de verre sont présentes dans la douille à une proportion comprise entre 20 et 40 % en poids.

7. Unité piézoélectrique d'actionneur (A) selon l'une des revendications précédentes, dans laquelle la pâte d'encapsulation (7) contient au moins l'un des matériaux suivants : un élastomère ou silicone, du sable de quartz et un agent de renforcement de l'adhérence.

8. Unité piézoélectrique d'actionneur (A) selon l'une des revendications précédentes dans laquelle le piézoactionneur (1) comporte une pile de couches piézocéramiques (2) et de couches d'électrode (3), des contacts extérieurs (4) de pôles électriques opposés disposés sur une surface latérale de la pile étant en contact avec des couches d'électrode (3).
